Europäisches Patentamt

(19) European Patent Office

Office européen des brevets

(11) Publication number: **0 445 968 A1**

# EUROPEAN PATENT APPLICATION

(21) Application number: **91301655.6**

(22) Date of filing: **28.02.91**

(51) Int. Cl.⁵: **C03C 14/00, H01B 3/08, H01L 21/48**

(30) Priority: **28.02.90 JP 45538/90**

(43) Date of publication of application: **11.09.91 Bulletin 91/37**

(84) Designated Contracting States: **DE FR GB**

(71) Applicant: **NEC CORPORATION**
**7-1, Shiba 5-chome Minato-ku Tokyo 108-01 (JP)**

(72) Inventor: **Kata, Keiichiro, c/o NEC Corporation**
**7-1, Shiba 5-chome**
**Minato-ku, Tokyo (JP)**
Inventor: **Shimada, Yuzo, c/o NEC Corporation**
**7-1, Shiba 5-chome**
**Minato-ku, Tokyo (JP)**

(74) Representative: **Abnett, Richard Charles et al**
**REDDIE & GROSE 16 Theobalds Road**
**London WC1X 8PL (GB)**

(54) **Low-temperature sinterable inorganic composition having low dielectric constant.**

(57) A low-temperature sinterable three-component system inorganic composition having low dielectric constant, comprising alumina, quartz glass and boro-silicate glass, each ingredient of the system being on each of lines which connects each of the following composition points in a three-component system composition diagram :

$(X=0, Y=0, Z=100)$ (a)
$(X=45, Y=0, Z=55)$ (b)
$(X=0, Y=45, Z=55)$ (c)

wherein X represents alumina, Y represents quartz glass and Z represents boro-silicate glass (weight % ratio) and $X + Y + Z = 100$, and being within the composition range which is defined by the three points. The composition can be sintered at a low temperature of not more than 1000°C and can be used as a multilayer ceramic substrate on which elements of an ultra high speed VLSI are mounted.

EP 0 445 968 A1

FIG. 2

# LOW-TEMPERATURE SINTERABLE INORGANIC COMPOSITION HAVING LOW DIELECTRIC CONSTANT

## BACKGROUND OF THE INVENTION

### 1. Field of the Invention

This invention relates to a low-temperature sinterable inorganic composition having low dielectric constant and more particularly an inorganic composition having low dielectric constant which can be sintered at a low temperature of not more than 1000 °C and which can be used as a multilayer ceramic substrate on which elements of an ultra-high speed VLSI are mainly mounted.

### 2. Description of the Prior Art

In the past, a semiconductor element of IC, LSI or the like has been mounted on a printed circuit substrate, such as a printed glass or epoxy substrate or the like, or an alumina ceramic substrate. With higher integration, microminiaturization and speeding-up of the semiconductor element, however, a highly densified and microminiaturized interconnection, higher speed transmission, higher frequency and higher thermal dissipation have been increasingly required also in the substrate on which the element is mounted. In the prior printed substrate, there were some problems with regard to through-hole plating, processability, multi-ply adhesion, thermal deformation at elevated temperatures or the like, and thus the higher densification had its limit. Therefore, the printed substrate on which the elements are mounted with high density has not been yet put to practical use. On the other hand, the ceramic substrate has possibility of practical use.

However, since the alumina substrate must be sintered also at elevated temperatures of not less than 1500°C, an interconnecting conductor material, which is sintered at the same time as the substrate, is limited to a high melting or refractory metal, such as W, Mo or the like, having relatively high resistivity. Thus, in the case that transmission loss in pulse signal is taken into consideration, there is a limit to microminiaturization in an interconnecting or wiring pattern.

Thus, a low-temperature sinterable multi layer ceramic substrate has been developed in the art. As an insulating material, there can be used a composite material of alumina and glass, crystallized glass or the like. Since these materials can be sintered at a temperature of not more than 1000°C, it is possible to use a low melting metal, such as AU, Ag-Pd, Cu or the like having low resistivity as the interconnecting conductor material. In addition, since it is possible to use a green sheet lamination technology, the highly densified and microminiaturized interconnection can be very advantageously made.

On the other hand, with respect to the higher speed transmission, it is necessary and essential to make dielectric constant of the substrate material lower since propagation delay time of pulse signal is proportional to a square root of the dielectric constant thereof. Although the low-temperature sinterable ceramic substrate which has been recently developed has the dielectric constant lower than that of the alumina substrate, satisfactorily lower dielectric constant is not attained, not to mention the alumina substrate (dielectric constant= about 10). Thus, the higher speed transmission needs yet to be improved.

For example, in low-temperature sinterable inorganic compositions having low dielectric constant, which are shown in Japanese Patent Publication Nos. 61-210195 and 61-218407, cordierite, quartz glass and rock crystal (α-quartz) which have low dielectric constant are used as a ceramic material but the lower dielectric constant is not satisfactorily attained because of the glass having the high dielectric constant.

## SUMMARY OF THE INVENTION

It is an object of this invention to settle the above problems in the prior art thereby to provide an inorganic composition which has sufficiently low dielectric constant and can be sintered at a low temperature of not more than 1000°C, said composition being used as an insulating layer in the multilayer ceramic substrate on which elements are mounted with high density.

The above object is accomplished by a low-temperature sinterable inorganic composition having low dielectric constant which comprises a three-component inorganic composition composed of alumina, quartz glass and boro-silicate glass as a ceramic material, each ingredient of the three-component system being on each of lines which connects each of the following composition points in a three-component system composition diagram:

$$(X=0, Y=0, Z=100) \quad (a)$$

$$(X=45, Y=0, Z=55) \quad (b)$$
$$(X=0, Y=45, Z=55) \quad (c)$$

wherein X represents alumina, Y represents quartz glass and Z represents boro-silicate glass (weight % ratio) and X + Y + Z = 100, and being within the composition range which is surrounded by the three points.

The above object is also accomplished by using the boro-silicate glass wherein a main ingredient is preferably within the following composition range; silicon oxide: 75 to 85 wt.%, boron oxide: 15 to 20 wt.%, aluminum oxide: 0.1 to 5 wt.%, oxides of elements of group I of a periodic table: 0.1 to 5 wt.%, oxides of elements of group II of the periodic table: 0.1 to 1 wt.% and titanium oxide: 0 to 0.05 wt.% according to conversion into oxides, these ingredients amounting to 100 wt.%.

BRIEF DESCRIPTION OF THE DRAWINGS

By way of example of the many features and advantages of the invention, an illustrative embodiment in the low-temperature sinterable inorganic composition having low dielectric constant is described below and shown in the accompanying drawings, in which:

Fig. 1 shows a composition diagram illustrating the composition range of the three-component system according to this invention and

Fig. 2 shows a diagram illustrating relationship between the composition range of the three-component system according to this invention and the composition points as shown in Examples and Comparative Examples.

DETAILED DESCRIPTION OF THE PREFERRED EMBODIMENT

The low-temperature sinterable inorganic composition having low dielectric constant according to this invention can be prepared, for example, by using materials and processes as mentioned below.

Namely, in preparing the boro-silicate glass, a raw material of each ingredient is weighed so as to become a target composition to make a batch and the resulting batch is heated for 2 to 4 hrs. at a high temperature of not less than 1400°C, is molten and is vitrified. The molten glass is watercooled or is run onto a thick iron plate to be formed into a flaky form and the resulting glass pieces are finely ground in an alumina ball mill or the like to obtain glass powder having an average particle diameter of 0.5 to 3 μm. On the other hand, the quartz glass is also ground to obtain finely divided powder having an average particle diameter of 0.5 to 5 μm.

Alumina and the above quartz glass powder are blended in the boro-silicate glass powder obtained by the above method so as to attain the target composition and the blend is mixed for 1 to 3 hrs. in a ball mill or the like to obtain a homogeneously mixed powder of the boro-silicate glass powder and the alumina and quartz glass powder, i.e. the low-temperature sinterable inorganic composition having low dielectric constant according to this invention. The boro-silicate glass powder as used above was notated by converting into oxides because of clarification but may be used with the form of mineral, oxide, carbonate, hydroxide or the like by a conventional method.

In addition, the thus obtained powdery inorganic composition of this invention is formed, for example, by a green sheet lamination technology. Namely, a vehicle is added to and mixed with the powder, sufficiently kneaded with a high speed mixer, a ball mill or the like and uniformly dispersed to prepare a slurry. Thereafter, the slurry is formed into a green sheet, which has a thickness suitable to form an insulating layer, by a slip casting method. Moreover, with regard to the organic vehicle such as a binder, solvent and the like, the ones which are ordinarily used are sufficient and no limit to the components thereof is required.

Then, a through-hole portion for connecting up-and-down electric conductors is formed in the sheet and thereafter printing on the conductors is performed so as to fill the through-hole portion with conductor paste, which is followed by laminating and hot press bonding to form the desired multilayer structure. By removing the organic vehicle which was added to the powder when forming and thereafter sintering the resulting structure, there is obtained a multilayer ceramic substrate.

According to this invention, the composition of the boro-silicate glass powder and alumina and quartz glass powder in the low-temperature sinterable inorganic composition having low dielectric constant and the composition of the boro-silicate glass powder itself are specified as set forth in the claim. Reasons and grounds on which the compositions are specified are as follows.

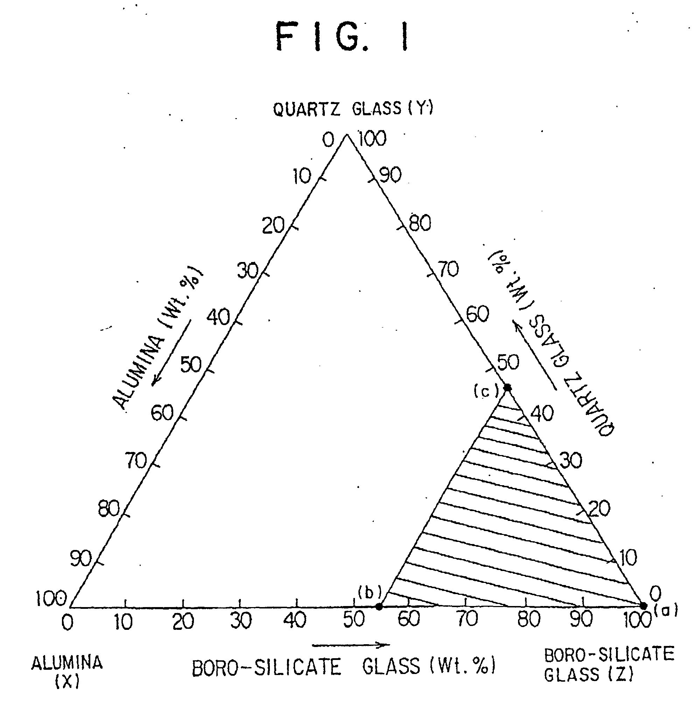

First, Fig. 1 shows a three-component composition diagram illustrating the composition range of each ingredient in the low-temperature sinterable inorganic composition having low dielectric constant according to this invention. In the drawing, (a), (b) and (c) represent each composition point and the composition range which can be included in this invention is in the shadowed portion and on the boundary lines.

In the three-component composition diagram which represents the composition range of each of the ingredients, with regard to the composition in a region wherein Z (the boro-silicate glass, weight % ratio) is less than 55 and is not included within the range of this invention, it is difficult to sinter the composition at a low temperature of not more than 1000°C and it is impossible to abtain a densified layer. Thus, water absorption takes place and reliability is decreased.

Next, with regard to the composition of the boro-silicate glass powder which is one of main ingredients of the low-temperature sinterable inorganic composition having low dielectric constant according to this invention, both of silicon oxide and boron oxide are a network former for glass. When the silicon oxide exceeds 85 wt.%, it is difficult to vitrify a mixture of the raw materials for the glass powder and even if the mixture was molten, the softening point of the glass is high and it is difficult to sinter it at a low temperature. On the other hand, when the silicon oxide is less than 75 wt.%, the softening point of the glass becomes too low, crystallization takes place with increase in the other ingredients, cristobalite or the like which has a bad influence upon coefficient of thermal expansion, which is one of important properties of the mounted substrate, is easily deposited or the dielectric constant which is the most important property is increased.

Now, with regard to the boron oxide, when it exceeds 20 wt.%, the softening point of the glass is sharply lowered and deformation or warpage easily takes place at the time of heat treatment. On the other hand, when the boron oxide is less than 15 wt.%, it becomes necessary to lower the softening point because of the silicon oxide being in much amount but there is no effect on such lowering and also inhibitory effect on crystallization due to the silicon oxide becomes insufficient.

All the other ingredients are added by a very small amount in order to control melting properties or stability of the glass but when the added amount is too much, the dielectric constant and coefficient of thermal expansion are raised. Thus, the ratio of silicon oxide to boron oxide in the boro-silicate glass powder takes on the most important meaning in this invention.

Next, this invention will be in detail explained with reference to the following examples and comparative examples. In these examples and comparative examples, all percentages are by weight, unless stated otherwise.

EXAMPLES 1 to 27 and COMPARATIVE EXAMPLES 1 to 3

Glass powder having the composition as shown in the composition ratio (I) in Table 1 was prepared and then the resulting powder was subjected to a wet milling for 48 hrs. with alcohol as a dispersing medium. The milled particles were passed through a sieve to put in order, and alcohol was removed by filteration and dried to obtain boro-silicate glass powder having a particle size of an average particle diameter of 1.9 μm and a BET specific surface of 12 m²/g.

Next, the obtained boro-silicate glass powder was blended with alumina powder having the average particle diameter of 1.0 μm and the BET specific surface of 3 m²/g and quartz glass powder having the average particle diameter of 3.7 μm and the BET specific surface of 6 m²/g, with the ratio as shown in Table 2. Namely, each of the powders was weighed with a prescribed amount, was mixed for 3 hrs. using alcohol as a dispersing medium in a ball mill and thereafter alcohol was removed by filtration and dried, to result in a homogenous powder mixture.

The thus obtained inorganic composition was evaluated by using a sample which was prepared by cutting a non-printing green laminate made according to a green sheet laminating, removing an organic vehicle from the cut laminate in an electric oven and thereafter sintering the resulting laminate. Samples which are within the composition range of this invention were sintered at 800 to 1000°C for 2 hrs. in the air. All the formulations as shown in Table 2 were made according to the above manner.

The evaluation on each sample was performed by measuring (1) a sintering temperature (the temperature at which water absorption does not take place, namely the temperature at which opening spaces eliminate), (2) dielectric constant, (3) insulation resistance and (4) coefficient of thermal expansion. The degree of water absorption was checked on difference between the weight of the sample which was prepared by placing it in water and boiling to sufficiently soak it with water and the weight of the dried sample. The dielectric constant was measured with 1 MHz. An electrode was formed by coating a conductive silver paste on the up-and-down surfaces of the sample and thereafter baking it at 600°C. The insulation resistance was measured with an applied voltage of 100V. The coefficient of thermal expansion was calculated on the basis of elongation of the sample from room temperature up to 250°C.

With regard to the thus obtained inorganic composition, relationship between the formulation ratio of alumina, quartz glass and boro-silicate glass and the sintering temperature, dielectric constant, insulation resistance and coefficient of thermal expansion is shown in Table 2.

As seen from Table 2, in the three-component inorganic composition composed of alumina, quartz glass and boro-silicate glass, the compositions which are within the composition range of this invention (Examples 1 to 27, composition points 1 to 27) have the sintering temperature of not more than 1000°C, namely the temperature at which no water absorption takes place in the sintered body and a densified structure is made, the much lower dielectric constant of 4.03 to 5.29 and the high insulation resistance of not less than $10^{13}\Omega\cdot cm$ and also retain insulating properties. In addition, the coefficient of thermal expansion is as low as 13.5 to 53.2 X $10^{-7}/$ °C and thus it can be seen that no deposition of high thermal expansive crystalline cristobalite due to crystallization of glass takes place.

On the other hand, in the compositions which are out of the composition range of this invention (Comparative examples 1 to 3, composition points 28 to 30), the sintering temperature is higher and the dielectric constant apparently becomes lower as the opening spaces remain when sintering the sample at a temperature of not more than 1000°C, but the insulation resistance is lower and thus a certain problem is raised on reliability.

EXAMPLES 28 to 54 and COMPARATIVE EXAMPLES 4 to 6

Glass having the composition ratio (II) as shown in Table 1 was prepared with a particle size of an average particle diameter of 2.0 μm and a BET specific surface of 11 $m^2$/g.

Samples were prepared by using the above boro-silicate glass powder and alumina and quartz glass powder with the formulation ratio as shown in Table 3 and were evaluated, according to the same procedure as that of Examples 1 to 27. The results are shown in Table 3.

As seen from Table 3, in the three-component inorganic composition composed of alumina, quartz glass and boro-silicate glass, the compositions which are within the composition range of this invention (Examples 28 to 54, composition points 1 to 27) have the sintering temperature of not more than 1000°C, namely the temperature at which no water absorption takes place in the sintered body and a densified structure is made, the much lower dielectric constant of 3.98 to 5.26 and the high insulation resistance of not less than $10^{13}\Omega\cdot cm$ and also retain insulating properties. In addition, the coefficient of thermal expansion is as low as 12.4 to 52.1 X $10^{-7}/$°C and thus it can be seen that no deposition of high thermal expansive crystalline cristrobalite due to crystallization of glass takes place.

On the other hand, in the compositions which are out of the composition range of this invention (Comparative examples 4 to 6, composition points 28 to 30), the sintering temperature is higher and the dielectric constant apparently becomes lower as the opening spaces remain when sintering the sample at a temperature of not more than 1000°C, but the insulation resistance is lower and thus a certain problem is raised on reliability.

EXAMPLES 55 to 81 and COMPARATIVE EXAMPLES 7 to 9

Glass having the composition ratio (III) as shown in Table 1 was prepared with a particle size of an average particle diameter of 1.8 μm and a BET specific surface of 12 $m^2$/g.

Samples were prepared by using the above boro-silicate glass powder and alumina and quartz glass powder with the formulation ratio as shown in Table 4 and were evaluated, according to the same procedure as that of Examples 1 to 27. The results are shown in Table 4.

As seen from Table 4, in the three-component inorganic composition composed of alumina, quartz glass and boro-silicate glass, the compositions which are within the composition range of this invention (Examples 55 to 81, composition points 1 to 27) have the sintering temperature of not more than 1000°C, namely the temperature at which no water absorption takes place in the sintered body and a densified structure is made, the much lower dielectric constant of 3.98 to 5.28 and the high insulation resistance of not less than $10^{13}\Omega\cdot cm$ and also retain insulating properties. In addition, the coefficient of thermal expansion is as low as 11.9 to 53.2 X $10^{-7}/$°C and thus it can be seen that no deposition of high thermal expansive crystalline cristobalite due to crystallization of glass takes place.

On the other hand, in the compositions which are out of the composition range of this invention (Comparative examples 7 to 9, composition points 28 to 30), the sintering temperature is higher and the dielectric constant apparently becomes lower as the opening spaces remain when sintering the sample at a temperature of not more than 1000°C but the insulation resistance is lower and thus a certain problem is raised on reliability.

EXAMPLES 82 to 108 and COMPARATIVE EXAMPLES 10 to 12

Glass having the composition ratio (IV) as shown in Table 1 was prepared with a particle size of an average particle diameter of 2.0 μm and a BET specific surface of 11 $m^2$/g.

Samples were prepared by using the above boro-silicate glass powder and alumina and quartz glass powder with the formulation ratio as shown in Table 5 and were evaluated, according to the same procedure as that of Examples 1 to 27. The results are shown in Table 5.

As seen from Table 5, in the three-component inorganic composition composed of alumina, quartz glass and boro-silicate glass, the compositions which are within the composition range of this invention (Examples 82 to 108, composition points 1 to 27) have the sintering temperature of not more than 1000°C, namely the temperature at which no water absorption takes place in the sintered body and a densified structure is made, the much lower dielectric constant of 4.04 to 5.32 and the high insulation resistance of not less than $10^{13}\Omega\cdot cm$ and also retain insulating properties. In addition, the coefficient of thermal expansion is as low as 13.7 to 53.0 $\times 10^{-7}/°C$ and thus it can be seen that no deposition of high thermal expansive crystalline crystobarite due to crystallization of glass takes place.

On the other hand, in the compositions which are out of the composition range of this invention (Comparative examples 10 to 12, composition points 28 to 30), the sintering temperature is higher and the dielectric constant apparently becomes lower as the opening spaces remain when calcining the sample at a temperature of not more than 1000°C but the insulation resistance is lower and thus a certain problem is raised on reliability.

EXAMPLES 109 to 135 and COMPARATIVE EXAMPLES 13 to 15

Glass having the composition ratio (V) as shown in Table 1 was prepared with a particle size of an average particle diameter of 1.8 μm and a BET specific surface of 12 m²/g.

Samples were prepared by using the above boro-silicate glass powder and alumina and quartz glass powder with the formulation ratio as shown in Table 6 and were evaluated, according to the same procedure as that of Examples 1 to 27. The results are shown in Table 6.

As seen from Table 6, in the three-component inorganic composition composed of alumina, quartz glass and boro-silicate glass, the compositions which are within the composition range of this invention (Examples 109 to 135, composition points 1 to 27) have the sintering temperature of not more than 1000°C, namely the temperature at which no water absorption takes place in the sintered body and a densified structure is made, the much lower dielectric constant of 3.99 to 5.31 and the high insulation resistance of not less than $10^{13}\Omega\cdot cm$ and also retain insulating properties. In addition, the coefficient of thermal expansion is as low as 12.7 to 53.1 $\times 10^{-7}/°C$ and thus it can be seen that no deposition of high thermal expansive crystalline cristobalite due to crystallization of glass takes place.

On the other hand, in the compositions which are out of the composition range of this invention (Comparative examples 13 to 15, composition points 28 to 30), the sintering temperature is higher and the dielectric constant apparently becomes lower as the opening spaces remain when sintering the sample at a temperature of not more than 1000°C, but the insulation resistance is lower and thus a certain problem is raised on reliability.

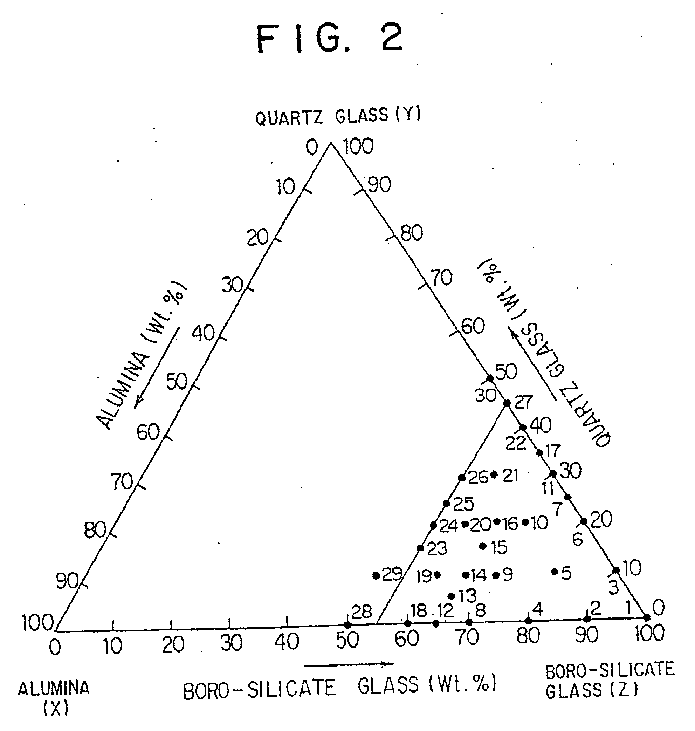

Moreover, each of the composition points in the formulation ratios of ingredients which were used in the above examples and comparative examples is shown in Fig. 2. Reference numbers 1, 2, ....., 30 as shown in the drawing correspond to the numbers of the formulation ratio as shown in Tables 2 to 6, respectively.

From the foregoing, it will be appreciated that the low-temperature sinterable inorganic composition having low dielectric constant according to this invention could attain dielectric constant lower than that of the prior alumina system, glass ceramic system and crystallized glass system, while maintaining reliability on the low-temperature sintering properties, insulating properties, water resistance and the like. Therefore, it became possible to provide a multi layer ceramic substrate for mounting the ultra-high speed VLSI elements thereon and thus it became possible to greatly contribute to improvement on the highly densified interconnection and the higher speed transmission.

Table 1

| INGREDIENT | COMPOSITION RATIO (Wt.%) | | | | |
|---|---|---|---|---|---|
| | (I) | (II) | (III) | (IV) | (V) |
| $SiO_2$ | 78.2 | 82.8 | 80.1 | 76.3 | 83.7 |
| $B_2O_3$ | 18.6 | 15.1 | 17.3 | 19.7 | 15.5 |
| $Na_2O$ | 0.09 | 0.04 | 0.05 | 0.12 | 0.04 |
| $K_2O$ | 1.93 | 1.60 | 1.42 | 2.20 | 0.07 |
| MgO | 0.09 | 0.07 | 0.10 | 0.19 | 0.08 |
| CaO | 0.04 | 0.04 | 0.03 | 0.06 | 0.02 |
| $Al_2O_3$ | 1.02 | 0.33 | 0.98 | 1.40 | 0.30 |
| $TiO_2$ | 0.03 | 0.02 | 0.02 | 0.03 | 0.02 |

Table 2

| | | FORMULATION RATIO OF INGREDIENTS (Wt.%) | | | SINTERING TEMPERATURE ($^\circ$C) | DIELECTRIC CONSTANT | INSULATION RESISTANCE ($\Omega \cdot$cm) | COEFFICIENT OF THERMAL EXPANSION ($\times 10^{-7}/^\circ$C) |
|---|---|---|---|---|---|---|---|---|
| | | NO. | ALUMINA | QUARTZ GLASS | BORO-SILICATE' GLASS | | | | |
| EXAMPLE 1 | 1 | 0 | 0 | 100 | 750 | 4.32 | >$10^{13}$ | 21.3 |
| " 2 | 2 | 10 | 0 | 90 | 750 | 4.46 | >$10^{13}$ | 22.0 |
| " 3 | 3 | 0 | 10 | 90 | 750 | 4.30 | >$10^{13}$ | 19.2 |
| " 4 | 4 | 20 | 0 | 80 | 750 | 4.77 | >$10^{13}$ | 40.9 |
| " 5 | 5 | 10 | 10 | 80 | 750 | 4.50 | >$10^{13}$ | 31.4 |
| " 6 | 6 | 0 | 20 | 80 | 750 | 4.25 | >$10^{13}$ | 19.0 |
| " 7 | 7 | 0 | 25 | 75 | 800 | 4.21 | >$10^{13}$ | 17.4 |
| " 8 | 8 | 30 | 0 | 70 | 850 | 4.92 | >$10^{13}$ | 47.7 |
| " 9 | 9 | 20 | 10 | 70 | 850 | 4.66 | >$10^{13}$ | 40.0 |
| " 10 | 10 | 10 | 20 | 70 | 850 | 4.43 | >$10^{13}$ | 27.5 |
| " 11 | 11 | 0 | 30 | 70 | 850 | 4.13 | >$10^{13}$ | 16.1 |
| " 12 | 12 | 35 | 0 | 65 | 900 | 5.22 | >$10^{13}$ | 48.9 |
| " 13 | 13 | 30 | 5 | 65 | 900 | 5.13 | >$10^{13}$ | 47.3 |
| " 14 | 14 | 25 | 10 | 65 | 900 | 4.73 | >$10^{13}$ | 42.9 |
| " 15 | 15 | 20 | 15 | 65 | 900 | 4.52 | >$10^{13}$ | 39.7 |

Table 2 (Cont.)

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION (x $10^{-7}$/°C) |
| | | ALUMINA | QUARTZ GLASS | BORO-SILICATE GLASS | | | | |
|---|---|---|---|---|---|---|---|---|
| EXAMPLE 16 | 16 | 15 | 20 | 65 | 900 | 4.50 | >$10^{13}$ | 35.3 |
| "   17 | 17 | 0 | 35 | 65 | 900 | 4.13 | >$10^{13}$ | 15.0 |
| "   18 | 18 | 40 | 0 | 60 | 950 | 5.29 | >$10^{13}$ | 53.2 |
| "   19 | 19 | 30 | 10 | 60 | 950 | 4.92 | >$10^{13}$ | 46.3 |
| "   20 | 20 | 20 | 20 | 60 | 950 | 4.63 | >$10^{13}$ | 39.2 |
| "   21 | 21 | 10 | 30 | 60 | 950 | 4.37 | >$10^{13}$ | 28.9 |
| "   22 | 22 | 0 | 40 | 60 | 950 | 4.03 | >$10^{13}$ | 14.0 |
| "   23 | 23 | 30 | 15 | 55 | 1000 | 4.92 | >$10^{13}$ | 45.0 |
| "   24 | 24 | 25 | 20 | 55 | 1000 | 4.75 | >$10^{13}$ | 43.2 |
| "   25 | 25 | 20 | 25 | 55 | 1000 | 4.63 | >$10^{13}$ | 39.7 |
| "   26 | 26 | 15 | 30 | 55 | 1000 | 4.52 | >$10^{13}$ | 35.3 |
| "   27 | 27 | 0 | 45 | 55 | 1000 | 4.07 | >$10^{13}$ | 13.5 |
| COMPARATIVE EXAMPLE   1 | 28 | 50 | 0 | 50 | 1050 | 5.70 | >$10^{13}$ | 56.2 |
| "   2 | 29 | 40 | 10 | 50 | 1050 | 5.30 | >$10^{13}$ | 53.1 |
| "   3 | 30 | 0 | 50 | 50 | 1050 | 4.00 | >$10^{13}$ | 11.9 |

EP 0 445 968 A1

Table 3

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION ($\times 10^{-7}/°C$) |
|---|---|---|---|---|---|---|---|---|
| | | ALUMINA | QUARTZ GLASS | BORO-SILICATE GLASS | | | | |
| EXAMPLE 28 | 1 | 0 | 0 | 100 | 750 | 4.30 | $>10^{13}$ | 20.0 |
| " 29 | 2 | 10 | 0 | 90 | 750 | 4.50 | $>10^{13}$ | 21.3 |
| " 30 | 3 | 0 | 10 | 90 | 750 | 4.24 | $>10^{13}$ | 18.1 |
| " 31 | 4 | 20 | 0 | 80 | 750 | 4.72 | $>10^{13}$ | 41.0 |
| " 32 | 5 | 10 | 10 | 80 | 750 | 4.45 | $>10^{13}$ | 31.1 |
| " 33 | 6 | 0 | 20 | 80 | 750 | 4.20 | $>10^{13}$ | 17.7 |
| " 34 | 7 | 0 | 25 | 75 | 800 | 4.17 | $>10^{13}$ | 16.1 |
| " 35 | 8 | 30 | 0 | 70 | 850 | 4.96 | $>10^{13}$ | 47.3 |
| " 36 | 9 | 20 | 10 | 70 | 850 | 4.66 | $>10^{13}$ | 39.8 |
| " 37 | 10 | 10 | 20 | 70 | 850 | 4.39 | $>10^{13}$ | 29.7 |
| " 38 | 11 | 0 | 30 | 70 | 850 | 4.09 | $>10^{13}$ | 15.1 |
| " 39 | 12 | 35 | 0 | 65 | 900 | 5.11 | $>10^{13}$ | 49.8 |
| " 40 | 13 | 30 | 5 | 65 | 900 | 5.05 | $>10^{13}$ | 46.7 |
| " 41 | 14 | 25 | 10 | 65 | 900 | 4.78 | $>10^{13}$ | 43.2 |
| " 42 | 15 | 20 | 15 | 65 | 900 | 4.63 | $>10^{13}$ | 39.2 |

EP 0 445 968 A1

Table 3 (Cont.)

| | NO. | FORMULATION RATIO OF INGREDIENTS (Wt.%) | | | SINTERING TEMPERATURE ($^{\circ}$C) | DIELECTRIC CONSTANT | INSULATION RESISTANCE ($\Omega \cdot$cm) | COEFFICIENT OF THERMAL EXPANSION (x $10^{-7}$/$^{\circ}$C) |
| | | ALUMINA | QUARTZ GLASS | BORO-SILICATE GLASS | | | | |
|---|---|---|---|---|---|---|---|---|
| EXAMPLE 43 | 16 | 15 | 20 | 65 | 900 | 4.49 | $>10^{13}$ | 34.6 |
| " 44 | 17 | 0 | 35 | 65 | 900 | 4.07 | $>10^{13}$ | 13.8 |
| " 45 | 18 | 40 | 0 | 60 | 950 | 5.26 | $>10^{13}$ | 52.1 |
| " 46 | 19 | 30 | 10 | 60 | 950 | 4.90 | $>10^{13}$ | 46.2 |
| " 47 | 20 | 20 | 20 | 60 | 950 | 4.60 | $>10^{13}$ | 38.7 |
| " 48 | 21 | 10 | 30 | 60 | 950 | 4.33 | $>10^{13}$ | 28.4 |
| " 49 | 22 | 0 | 40 | 60 | 950 | 4.00 | $>10^{13}$ | 13.0 |
| " 50 | 23 | 30 | 15 | 55 | 1000 | 4.87 | $>10^{13}$ | 45.7 |
| " 51 | 24 | 25 | 20 | 55 | 1000 | 4.71 | $>10^{13}$ | 42.2 |
| " 52 | 25 | 20 | 25 | 55 | 1000 | 4.56 | $>10^{13}$ | 38.1 |
| " 53 | 26 | 15 | 30 | 55 | 1000 | 4.43 | $>10^{13}$ | 33.3 |
| " 54 | 27 | 0 | 45 | 55 | 1000 | 3.98 | $>10^{13}$ | 12.4 |
| COMPARATIVE EXAMPLE 4 | 28 | 50 | 0 | 50 | 1050 | 5.61 | $>10^{13}$ | 55.8 |
| " 5 | 29 | 40 | 10 | 50 | 1050 | 5.19 | $>10^{13}$ | 51.2 |
| " 6 | 30 | 0 | 50 | 50 | 1050 | 3.92 | $>10^{13}$ | 11.5 |

EP 0 445 968 A1

Table 4

| | | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION ($\times 10^{-7}/°C$) |
| | NO. | ALUMINA | QUARTZ GLASS | BORO-SILICATE GLASS | | | | |
|---|---|---|---|---|---|---|---|---|
| EXAMPLE 55 | 1 | 0 | 0 | 100 | 750 | 4.30 | $>10^{13}$ | 22.3 |
| " 56 | 2 | 10 | 0 | 90 | 750 | 4.52 | $>10^{13}$ | 22.1 |
| " 57 | 3 | 0 | 10 | 90 | 750 | 4.37 | $>10^{13}$ | 19.3 |
| " 58 | 4 | 20 | 0 | 80 | 750 | 4.76 | $>10^{13}$ | 43.0 |
| " 59 | 5 | 10 | 10 | 80 | 750 | 4.49 | $>10^{13}$ | 33.2 |
| " 60 | 6 | 0 | 20 | 80 | 750 | 4.30 | $>10^{13}$ | 18.7 |
| " 61 | 7 | 0 | 25 | 75 | 800 | 4.10 | $>10^{13}$ | 16.9 |
| " 62 | 8 | 30 | 0 | 70 | 850 | 5.00 | $>10^{13}$ | 47.4 |
| " 63 | 9 | 20 | 10 | 70 | 850 | 4.72 | $>10^{13}$ | 40.2 |
| " 64 | 10 | 10 | 20 | 70 | 850 | 4.44 | $>10^{13}$ | 29.8 |
| " 65 | 11 | 0 | 30 | 70 | 850 | 4.11 | $>10^{13}$ | 16.8 |
| " 66 | 12 | 35 | 0 | 65 | 900 | 5.10 | $>10^{13}$ | 49.7 |
| " 67 | 13 | 30 | 5 | 65 | 900 | 5.03 | $>10^{13}$ | 45.3 |
| " 68 | 14 | 25 | 10 | 65 | 900 | 4.79 | $>10^{13}$ | 42.9 |
| " 69 | 15 | 20 | 15 | 65 | 900 | 4.65 | $>10^{13}$ | 40.2 |

EP 0 445 968 A1

Table 4 (Cont.)

| | | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION ($\times 10^{-7}/°C$) |
|---|---|---|---|---|---|---|---|---|
| | NO. | ALUMINA | QUARTZ GLASS | BORO-SILICATE GLASS | | | | |
| EXAMPLE 70 | 16 | 15 | 20 | 65 | 900 | 4.52 | $>10^{13}$ | 35.3 |
| " 71 | 17 | 0 | 35 | 65 | 900 | 4.11 | $>10^{13}$ | 14.2 |
| " 72 | 18 | 40 | 0 | 60 | 950 | 5.28 | $>10^{13}$ | 53.2 |
| " 73 | 19 | 30 | 10 | 60 | 950 | 4.95 | $>10^{13}$ | 47.3 |
| " 74 | 20 | 20 | 20 | 60 | 950 | 4.62 | $>10^{13}$ | 39.3 |
| " 75 | 21 | 10 | 30 | 60 | 950 | 4.42 | $>10^{13}$ | 37.4 |
| " 76 | 22 | 0 | 40 | 60 | 950 | 3.98 | $>10^{13}$ | 14.3 |
| " 77 | 23 | 30 | 15 | 55 | 1000 | 4.92 | $>10^{13}$ | 43.2 |
| " 78 | 24 | 25 | 20 | 55 | 1000 | 4.83 | $>10^{13}$ | 44.4 |
| " 79 | 25 | 20 | 25 | 55 | 1000 | 4.72 | $>10^{13}$ | 39.2 |
| " 80 | 26 | 15 | 30 | 55 | 1000 | 4.39 | $>10^{13}$ | 37.2 |
| " 81 | 27 | 0 | 45 | 55 | 1000 | 3.98 | $>10^{13}$ | 11.9 |
| COMPARATIVE EXAMPLE 7 | 28 | 50 | 0 | 50 | 1050 | 5.72 | $>10^{13}$ | 57.2 |
| " 8 | 29 | 40 | 10 | 50 | 1050 | 5.21 | $>10^{13}$ | 52.3 |
| " 9 | 30 | 0 | 50 | 50 | 1050 | 3.98 | $>10^{13}$ | 10.1 |

Table 5

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION (x $10^{-7}$/°C) |
|---|---|---|---|---|---|---|---|---|
| | | ALUMINA | QUARTZ GLASS | BORO-SILICATE GLASS | | | | |
| EXAMPLE 82 | 1 | 0 | 0 | 100 | 750 | 4.38 | $>10^{13}$ | 21.4 |
| " 83 | 2 | 10 | 0 | 90 | 750 | 4.53 | $>10^{13}$ | 22.5 |
| " 84 | 3 | 0 | 10 | 90 | 750 | 4.32 | $>10^{13}$ | 19.2 |
| " 85 | 4 | 20 | 0 | 80 | 750 | 4.75 | $>10^{13}$ | 42.1 |
| " 86 | 5 | 10 | 10 | 80 | 750 | 4.49 | $>10^{13}$ | 30.9 |
| " 87 | 6 | 0 | 20 | 80 | 750 | 4.25 | $>10^{13}$ | 18.6 |
| " 88 | 7 | 0 | 25 | 75 | 800 | 4.20 | $>10^{13}$ | 17.2 |
| " 89 | 8 | 30 | 0 | 70 | 850 | 4.92 | $>10^{13}$ | 48.7 |
| " 90 | 9 | 20 | 10 | 70 | 850 | 4.63 | $>10^{13}$ | 39.9 |
| " 91 | 10 | 10 | 20 | 70 | 850 | 4.43 | $>10^{13}$ | 30.1 |
| " 92 | 11 | 0 | 30 | 70 | 850 | 4.17 | $>10^{13}$ | 16.2 |
| " 93 | 12 | 35 | 0 | 65 | 900 | 5.25 | $>10^{13}$ | 49.2 |
| " 94 | 13 | 30 | 5 | 65 | 900 | 5.13 | $>10^{13}$ | 47.3 |
| " 95 | 14 | 25 | 10 | 65 | 900 | 4.93 | $>10^{13}$ | 44.5 |
| " 96 | 15 | 20 | 15 | 65 | 900 | 4.52 | $>10^{13}$ | 40.2 |

EP 0 445 968 A1

Table 5 (Cont.)

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION ($\times 10^{-7}/°C$) |
| | | ALUMINA | QUARTZ GLASS | BORO-SILICATE GLASS | | | | |
|---|---|---|---|---|---|---|---|---|
| EXAMPLE 97 | 16 | 15 | 20 | 65 | 900 | 4.53 | $>10^{13}$ | 35.3 |
| " 98 | 17 | 0 | 35 | 65 | 900 | 4.14 | $>10^{13}$ | 15.0 |
| " 99 | 18 | 40 | 0 | 60 | 950 | 5.32 | $>10^{13}$ | 53.0 |
| " 100 | 19 | 30 | 10 | 60 | 950 | 4.90 | $>10^{13}$ | 46.7 |
| " 101 | 20 | 20 | 20 | 60 | 950 | 4.62 | $>10^{13}$ | 40.1 |
| " 102 | 21 | 10 | 30 | 60 | 950 | 4.43 | $>10^{13}$ | 29.8 |
| " 103 | 22 | 0 | 40 | 60 | 950 | 4.08 | $>10^{13}$ | 14.2 |
| " 104 | 23 | 30 | 15 | 55 | 1000 | 4.95 | $>10^{13}$ | 46.2 |
| " 105 | 24 | 25 | 20 | 55 | 1000 | 4.83 | $>10^{13}$ | 42.3 |
| " 106 | 25 | 20 | 25 | 55 | 1000 | 4.57 | $>10^{13}$ | 39.2 |
| " 107 | 26 | 15 | 30 | 55 | 1000 | 4.41 | $>10^{13}$ | 34.5 |
| " 108 | 27 | 0 | 45 | 55 | 1000 | 4.04 | $>10^{13}$ | 13.7 |
| COMPARATIVE EXAMPLE 10 | 28 | 50 | 0 | 50 | 1050 | 5.83 | $>10^{13}$ | 57.2 |
| " 11 | 29 | 40 | 10 | 50 | 1050 | 5.25 | $>10^{13}$ | 50.0 |
| " 12 | 30 | 0 | 50 | 50 | 1050 | 4.02 | $>10^{13}$ | 12.6 |

EP 0 445 968 A1

16

Table 6

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION (x $10^{-7}/$°C) |
| | | ALUMINA | QUARTZ GLASS | BORO-SILICATE GLASS | | | | |
|---|---|---|---|---|---|---|---|---|
| EXAMPLE 109 | 1 | 0 | 0 | 100 | 750 | 4.30 | $>10^{13}$ | 22.3 |
| " 110 | 2 | 10 | 0 | 90 | 750 | 4.53 | $>10^{13}$ | 21.7 |
| " 111 | 3 | 0 | 10 | 90 | 750 | 4.27 | $>10^{13}$ | 19.0 |
| " 112 | 4 | 20 | 0 | 80 | 750 | 4.72 | $>10^{13}$ | 42.1 |
| " 113 | 5 | 10 | 10 | 80 | 750 | 4.46 | $>10^{13}$ | 32.5 |
| " 114 | 6 | 0 | 20 | 80 | 750 | 4.19 | $>10^{13}$ | 18.3 |
| " 115 | 7 | 0 | 25 | 75 | 800 | 4.17 | $>10^{13}$ | 17.1 |
| " 116 | 8 | 30 | 0 | 70 | 850 | 4.88 | $>10^{13}$ | 16.7 |
| " 117 | 9 | 20 | 10 | 70 | 850 | 4.68 | $>10^{13}$ | 48.2 |
| " 118 | 10 | 10 | 20 | 70 | 850 | 4.43 | $>10^{13}$ | 42.1 |
| " 119 | 11 | 0 | 30 | 70 | 850 | 4.11 | $>10^{13}$ | 18.1 |
| " 120 | 12 | 35 | 0 | 65 | 900 | 5.21 | $>10^{13}$ | 50.2 |
| " 121 | 13 | 30 | 5 | 65 | 900 | 5.07 | $>10^{13}$ | 49.2 |
| " 122 | 14 | 25 | 10 | 65 | 900 | 4.93 | $>10^{13}$ | 45.8 |
| " 123 | 15 | 20 | 15 | 65 | 900 | 4.42 | $>10^{13}$ | 44.3 |

EP 0 445 968 A1

Table 6 (Cont.)

| | NO. | FORMULATION RATIO OF INGREDIENTS (Wt.%) | | | SINTERING TEMPERATURE (°C) | DIELECTRIC CONSTANT | INSULATION RESISTANCE ($\Omega \cdot cm$) | COEFFICIENT OF THERMAL EXPANSION (x $10^{-7}$/°C) |
| | | ALUMINA | QUARTZ GLASS | BORO-SILICATE GLASS | | | | |
|---|---|---|---|---|---|---|---|---|
| EXAMPLE 124 | 16 | 15 | 20 | 65 | 900 | 4.53 | $>10^{13}$ | 35.3 |
| " 125 | 17 | 0 | 35 | 65 | 900 | 4.12 | $>10^{13}$ | 13.8 |
| " 126 | 18 | 40 | 0 | 60 | 950 | 5.31 | $>10^{13}$ | 53.1 |
| " 127 | 19 | 30 | 10 | 60 | 950 | 4.86 | $>10^{13}$ | 46.7 |
| " 128 | 20 | 20 | 20 | 60 | 950 | 4.59 | $>10^{13}$ | 40.1 |
| " 129 | 21 | 10 | 30 | 60 | 950 | 4.42 | $>10^{13}$ | 28.9 |
| " 130 | 22 | 0 | 40 | 60 | 950 | 3.97 | $>10^{13}$ | 12.7 |
| " 131 | 23 | 30 | 15 | 55 | 1000 | 4.75 | $>10^{13}$ | 46.3 |
| " 132 | 24 | 25 | 20 | 55 | 1000 | 4.82 | $>10^{13}$ | 43.2 |
| " 133 | 25 | 20 | 25 | 55 | 1000 | 4.52 | $>10^{13}$ | 39.2 |
| " 134 | 26 | 15 | 30 | 55 | 1000 | 4.40 | $>10^{13}$ | 34.5 |
| " 135 | 27 | 0 | 45 | 55 | 1000 | 3.99 | $>10^{13}$ | 13.9 |
| COMPARATIVE EXAMPLE 13 | 28 | 50 | 0 | 50 | 1050 | 5.81 | $>10^{13}$ | 57.0 |
| " 14 | 29 | 40 | 10 | 50 | 1050 | 5.32 | $>10^{13}$ | 53.2 |
| " 15 | 30 | 0 | 50 | 50 | 1050 | 3.91 | $>10^{13}$ | 11.5 |

EP 0 445 968 A1

## Claims

1. A low-temperature sinterable inorganic composition having low dielectric constant which comprises a three-component inorganic composition composed of alumina, quartz glass and boro-silicate glass as a ceramic material, each ingredient of the three-component system being on each of lines which connects each of the following composition points in a three-component system composition diagram:

(X=0, Y=0, Z=100)
(X=45, Y=0, Z=55)
(X=0, Y=45, Z=55)

wherein X represents alumina, Y represents quartz glass and Z represents boro-silicate glass (weight % ratio) and X + Y + Z = 100, and being within the composition range which is defined by the three points.

2. A low-temperature sinterable inorganic composition having low dielectric constant as set forth in claim 1, wherein a main ingredient of the boro-silicate glass is within the following composition range; silicon oxide: 75 to 85 wt.%, boron oxide: 15 to 20 wt.%, aluminum oxide: 0.1 to 5 wt.%, oxides of elements of group I of a periodic table: 0.1 to 5 wt.%, oxides of elements of group II thereof: 0.1 to 1 wt.% and titanium oxide: 0 to 0.05 wt.% according to conversion into oxides, these ingredients amounting to 100 wt.%.

3. A low-temperature sinterable inorganic composition having a low dielectric constant, the composition comprising alumina and glass, characterised in that the composition is a three-component inorganic composition composed of alumina, quartz glass, and boro-silicate glass, the composition being within the composition range which is defined on a three-component system composition diagram by lines joining the points:

(X = 0, Y = 0, Z = 100)
(X = 45, Y = 0, Z = 55)
(X = 0, Y = 45, Z = 55)

where X represents alumina, Y represents quartz glass, and Z represents boro-silicate glass, and the figures are weight percent.

# F I G. I

QUARTZ GLASS (Y)

ALUMINA (Wt. %)

QUARTZ GLASS (Wt. %)

BORO-SILICATE GLASS (Wt. %)

ALUMINA (X)

BORO-SILICATE GLASS (Z)

# FIG. 2

Ternary diagram with axes QUARTZ GLASS (Y), ALUMINA (Wt.%), BORO-SILICATE GLASS (Wt.%), ALUMINA (X), BORO-SILICATE GLASS (Z), QUARTZ GLASS (Wt.%)

**European Patent Office**

**EUROPEAN SEARCH REPORT**

Application Number

EP 91 30 1655

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | EP-A-0 326 093 (E.I. DU PONT DE NEMOURS)<br>* Claim 1; page 8, table 3 *<br>--- | 1-3 | C 03 C 14/00<br>H 01 B 3/08<br>H 01 L 21/48 |
| Y | CHEMICAL ABSTRACTS, vol. 108, no. 20, 16th May 1988, page 754, abstract no. 178538t, Columbus, Ohio, US; & JP-A-62 209 895 (MATSUSHITA) 16-09-1987<br>* Complete abstract *<br>----- | 2 | |

TECHNICAL FIELDS SEARCHED (Int. Cl.5)

C 03 C

The present search report has been drawn up for all claims

| Place of search | Date of completion of the search | Examiner |
|---|---|---|
| THE HAGUE | 22-05-1991 | BOUTRUCHE J.P.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)